# EUROPEAN PATENT APPLICATION

(11) **EP 3 907 474 A1**
(43) Date of publication of application: **10.11.2021**
(21) Application number: 19906884.2
(22) Date of filing: 11.09.2019
(51) Int. Cl.: G01D 5/12

(54) **ROTATION DETECTION MODULE AND ELECTRONIC DEVICE COMPRISING SAME**

(30) Priority: 04.01.2019 CN 201920015947 U
(71) Applicant: Anhui Huami Information Technology Co., Ltd., Hefei, Anhui 230088 (CN)
(72) Inventor: LV, Baitao, Hefei, Anhui 230088 (CN); HUANG, Weiwei, Hefei, Anhui 230088 (CN); ZHANG, Lian, Hefei, Anhui 230088 (CN); YU, Delian, Hefei, Anhui 230088 (CN); TIAN, Yuan, Hefei, Anhui 230088 (CN)
(74) Representative: Angerhausen, Christoph
(86) International application number: PCT/CN2019/105254
(87) International publication number: WO 2020/140473

(57) **Abstract**

A rotation detection module and an electronic device containing the same are provided. The rotation detection module includes: a housing (10), wherein the material of the housing (10) is a magnetic shielding material; a rotating component (20) penetrating the housing (10); a magnetic component (30) located in the housing (10) and rotating integrally with the rotating component (20); and a magnetic sensor (40) located in the housing (10) and arranged relative to the magnetic component (30), wherein the magnetic sensor (40) is configured to sense a rotation angle of the magnetic component (30) and/or sense displacement of the magnetic component (30) in an axial direction the rotating component (20).

## Description

### CROSS-REFERENCE TO RELATED APPLICATION(S)

The present application is based on and claims to a Chinese patent application No. 201920015947.8 filed on January 4, 2019, the contents of which are hereby incorporated into this application by reference in its entirety.

### TECHNICAL FIELD

The present application relates to the technical field of electronic devices, and in particular, to a rotation detection module and an electronic device containing the same.

### BACKGROUND

Smart watches have gradually been widely used because of their diversified functions and practicality. Current interactive modes of smart watches mainly include buttons, touch screens, voice, and (watch) crowns. In some instances, for example, the crown can be used for two categories of functions in a smart watch: a key operation, and a rotation operation.

The crown can be implemented, for example, by a mechanical encoder, an optical method, and/or a magnetic method.

The mechanical encoder can encode a state of a watch spindle, and the rotation of the watch spindle is judged by reading a change in the encoding through a MCU (Microcontroller Unit).

For the optical method, a watch hand rotating and pressing trajectory is tracked based on the optical navigation technology, and is automatically processed into a digital quantity in a sensor, a master control reads this digital quantity for processing, and then performs an operation such as switching a smart watch APP menu.

For the magnetic method, detection of crown rotation is realized by setting a magnetic body and a magnetic sensor.

In the above crown implementations, the mechanical encoder has a reliability problem such as a small number of tolerance operations, and also has the problem of low rotation resolution. The optical method incurs high cost and relatively high power consumption. In the magnetic method, since the magnetic field of the magnetic body is easily affected by the surrounding magnetic field, its accuracy is reduced.

### SUMMARY

The present application provides a rotation detection module and an electronic device containing the same, which can improve the accuracy of a detection result and has beneficial effects of low cost and high versatility.

To achieve the above objective, a rotation detection module is provided in an implementation of the present application. The rotation detection module includes: a housing, wherein the material of the housing is a magnetic shielding material; a rotating component penetrating the housing; a magnetic component located in the housing and rotating integrally with the rotating component; and a magnetic sensor located in the housing and arranged relative to the magnetic component, wherein the magnetic sensor is configured to sense at least one of: a rotation angle of the magnetic component or displacement of the magnetic component in an axial direction of the rotating component.

In some implementations of the present application, the rotation detection module further includes a flexible circuit board inserted into the housing, and the magnetic sensor is arranged at one end the flexible circuit board located in the housing.

In some implementations of the present application, the end of the flexible circuit board located in the housing is fixed to an inner surface of the housing.

In some implementations of the present application, an adhesive layer is arranged between the end of the flexible circuit board located in the housing and the inner surface of the housing, and the flexible circuit board is fixed to the inner surface of the housing through the adhesive layer.

In some implementations of the present application, the rotation detection module further includes a damping component arranged in the housing, and the damping component cooperates with the rotating component to limit the rotation of the rotating component.

In some implementations of the present application, the damping component and the rotating component are snap-fitted to limit the rotation of the rotating component.

In some implementations of the present application, an end portion of the rotating component is provided with a gear, and the damping component and the gear are snap-fitted to limit the rotation of the gear.

In some implementations of the present application, the damping component is an elastic structural body, and an end portion of the elastic structural body is clamped in a tooth space of the gear to limit the rotation of the gear.

In some implementations of the present application, the rotation detection module further includes a knob fixedly connected to the end portion of the rotating component and arranged outside the housing.

In some implementations of the present application, the rotation detection module further includes a damping component arranged relative to the knob, and the damping component cooperates with the knob to limit the rotation of the rotating component.

An electronic device is further provided in an implementation of the present application, which includes the rotation detection module as described above.

In the rotation detection module of the above implementation, the overall structure is arranged to effectively reduce leakage of a magnetic field inside the housing and the impact of a magnetic field outside the housing to the rotation detection module, thereby improving the accuracy of detection. Moreover, the universal modular setting effectively reduces the production cost and has the beneficial effect of high versatility.

### BRIEF DESCRIPTION OF DRAWINGS

FIG. 1 to FIG. 9 are structural views of a rotation detection module according to Implementation 1.
FIG. 1 is a three-dimensional structural view of a rotation detection module according to Implementation 1;
FIG. 2 is a three-dimensional structural view of a rotation detection module according to Implementation 1 from another perspective;
FIG. 3 is a cross-sectional view taken in a direction A-A in FIG. 2;
FIG. 4 is a three-dimensional structural view of a rotation detection module according to Implementation 1 from still another perspective;
FIG. 5 is a structural view of a magnetic component according to Implementation 1;
FIG. 6 is a schematic diagram of relative positions of a magnetic component and a magnetic sensor according to Implementation 1;
FIG. 7 is a diagram showing a relationship between a three-axis magnetic induction intensity and phase of a magnetic sensor and an angle of a magnetic component according to Implementation 1 when the magnetic component rotates by one circle;
FIG. 8 is a structural view of another implementation of a magnetic component according to Implementation 1; and
FIG. 9 is a schematic diagram of relative positions of another implementation of a magnetic component and a magnetic sensor according to Implementation 1.
FIG. 10 is a three-dimensional structural view of a rotation detection module according to Implementation 2.

### Description of Reference Numerals

Housing 10, rotating component 20, magnetic component 30, magnetic sensor 40, flexible circuit board 50, connector 60, elastic structural body 70, gear 80, tooth space 81, knob 90, groove 91, and axial direction F of the rotating component.

### DETAILED DESCRIPTION

Example implementations will be described in detail here, and examples thereof are shown in the accompanying drawings. When the following description refers to the accompanying drawings, unless otherwise indicated, the same numerals in different accompanying drawings indicate the same or similar elements. Implementations described in the following example implementations do not represent all implementations consistent with the present application. On the contrary, they are merely examples of devices consistent with some aspects of the present application as detailed in the appended claims.

Terms used in the present application are only for the purpose of describing specific implementations, and are not intended to limit the present application. Unless otherwise defined, technical or scientific terms used in the present application shall have general meanings understood by those of general skills in the art to which the present application belongs. Similar words such as "one" or "a" used in the specification and claims of the present application do not mean a quantity limit, but mean that there is at least one. Similar words such as "including" and "containing" mean that an element or item before "including" or "containing" covers an element, item, or its equivalent listed after "including" or "containing," and does not exclude other elements or items. Similar words such as "connect" or "connected" are not limited to physical or mechanical connections, and may include electrical connections, whether direct or indirect. "Multiple" includes two and is equivalent to at least two. Singular forms of "a," "said," and "the" used in the specification and appended claims of the present application are also intended to include plural forms, unless the context clearly indicates other meanings. It should also be understood that the term "and/or" as used herein refers to and includes any or all possible combinations of one or more associated listed items.

### Implementation 1

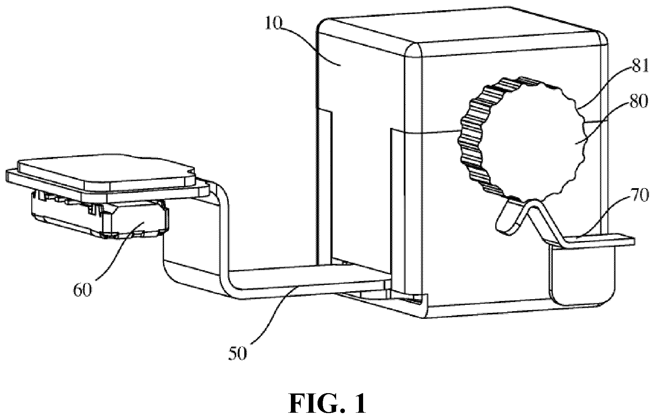

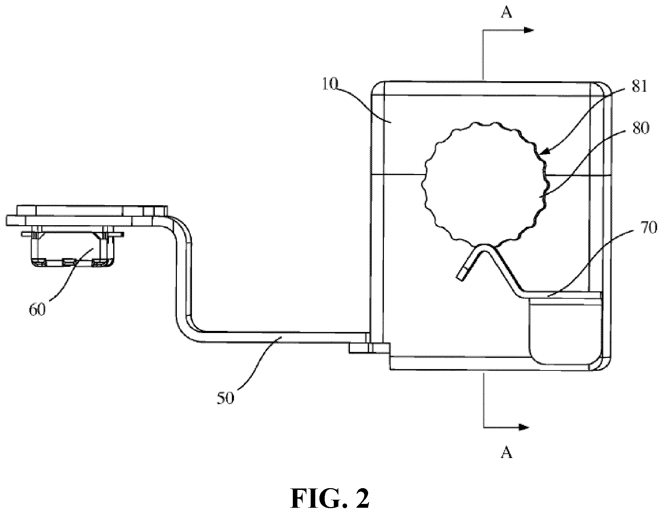

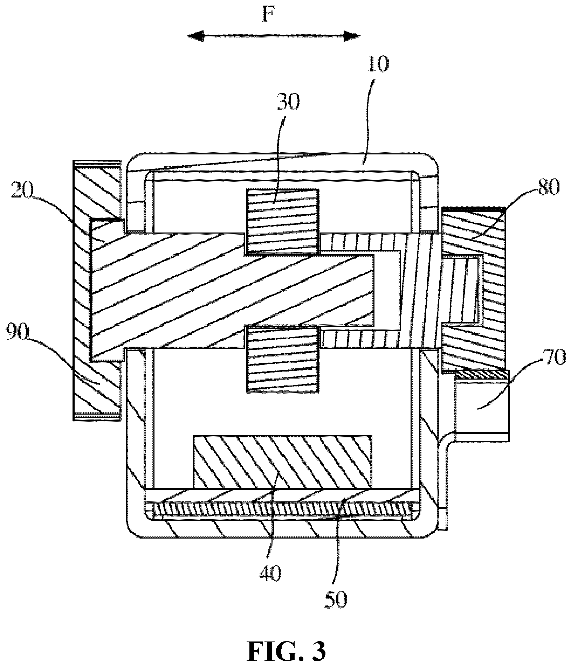

FIG. 1 to FIG. 9 are structural views of a rotation detection module according to Implementation 1.

Implementation 1 of the present application provides a rotation detection module, which is applied to an electronic device and configured to detect rotation and displacement of related components in a device, such as applied in a smart wearable device, specifically, for example, in a crown of a smart watch. For another example, it may be applied to detection of motor rotation, and may also be applied to detection of bicycle wheel rotation parameters.

In the present implementation, the rotation detection module includes: housing 10, rotating component 20, magnetic component 30, magnetic sensor 40, flexible circuit board 50, and connector 60.

The material of housing 10 is a magnetic shielding material. For example, magnetic shielding material Steel Plate Cold (SPC) series products available can be used, and the series products can be all steel products. The first English letter in the English abbreviation SPC indicates the material, that is, S (Steel) indicates steel; the second English letter in SPC indicates the shape type and purpose, that is, P (Plate) indicates plate; and the third English letter indicates the type of steel, that is, C (Cold) indicates cold rolled. The SPC series products include products of different grades such as SPCE and SPCD. The fourth English letter indicates the stamping level. For example, E (Elongation) indicates elongation level; and D (deep drawn) indicates deep drawn level.

Rotating component 20 penetrates housing 10. Magnetic component 30 is located in housing 10, and magnetic component 30 is fixedly connected to rotating component 20 and rotates integrally with rotating component 20. Magnetic sensor 40 is located in housing 10 and is arranged relative to magnetic component 30. Magnetic sensor 40 is configured to sense a rotation angle of magnetic component 30 and/or sense displacement of magnetic component 30 in axial direction F of the rotating component.

In this way, by arranging magnetic component 30 and magnetic sensor 40 in housing 10 and setting the material of housing 10 as a magnetic shielding material, on the one hand, external magnetic radiation of magnetic component 30 in the rotation detection module can be reduced; on the other hand, interference of a magnetic field outside the rotation detection module to an internal magnetic field can be reduced, and the detection accuracy of magnetic sensor 40 can be enhanced.

Flexible circuit board 50 is inserted into housing 10, and magnetic sensor 40 is arranged at one end of flexible circuit board 50 located in housing 10. Connector 60 is provided at one end of flexible circuit board 50 located outside housing 10 and is configured to be connected to an electronic device. Connector 60 is configured for power and signal connection with a mainboard. By arranging flexible circuit board 50, the rotation detection module can be more easily assembled in different electronic devices. Magnetic sensor 40 is mounted on flexible circuit board 50 through SMT (Surface Mount Technology).

In the present implementation, one end of flexible circuit board 50 located in housing 10 is fixed to an inner surface of housing 10. Specifically, an adhesive layer (not shown in the drawing) is arranged between the end of flexible circuit board 50 located in housing 10 and the inner surface of housing 10, and flexible circuit board 50 is fixed to the inner surface of housing 10 through the adhesive layer.

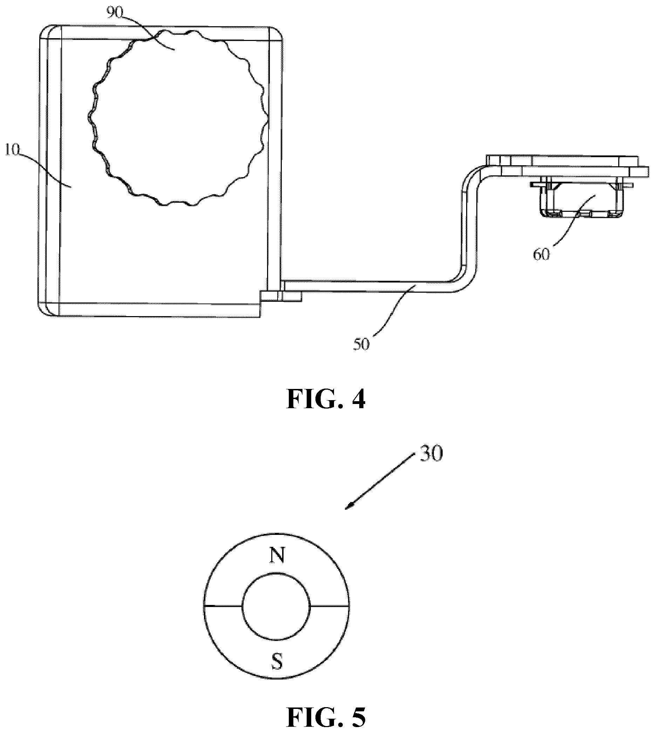

In the present implementation, the rotation detection module is applied to a smart wearable device. The rotation detection module is used as a crown, rotating component 20 is a rotating shaft, magnetic component 30 is a magnet, and magnetic component 30 is in a shape of a closed ring structure, as shown in FIG. 5.

Magnetic component 30 rotates along with rotating component 20, and positions of an N pole and an S pole of magnetic component 30 change during rotation. Magnetic sensor 40 is located below magnetic component 30, can detect the changes of the N pole and the S pole of magnetic component 30, and provide a current angle of rotating component 20 according to the strengths of the N pole and the S pole.

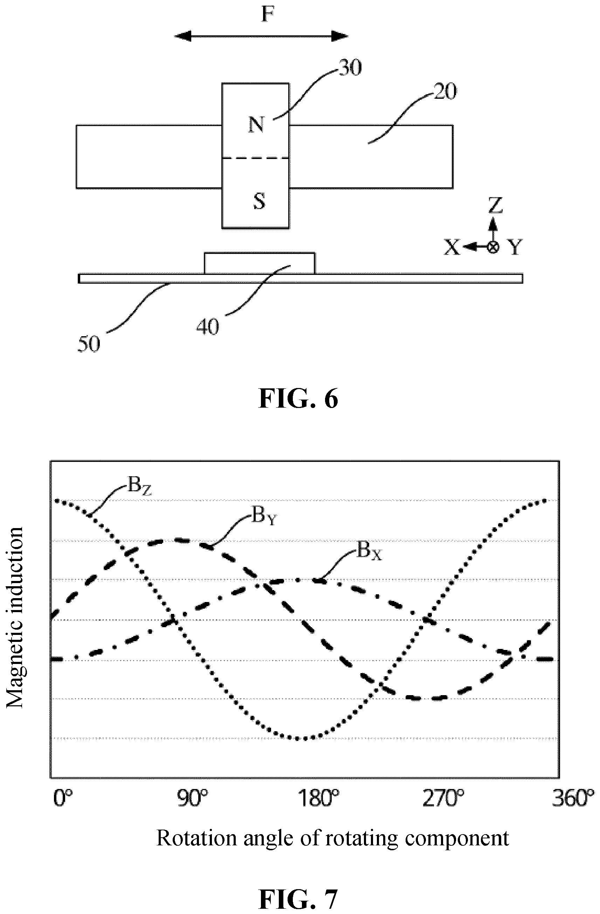

In FIG. 6, a position of magnetic component 30 relative to rotating component 20 and a relative position of magnetic sensor 40 are shown. That is, annular magnetic component 30 is sleeved outside rotating component 20, and magnetic sensor 40 is located directly below magnetic component 30. The N pole of magnetic component 30 is arranged at an end of magnetic component 30 away from magnetic sensor 40, and the S pole of magnetic component 30 is arranged at an end of magnetic component 30 close to magnetic sensor 40. The detection principle of magnetic sensor 40 is as follows: the N pole and the S pole of magnetic component 30 cause a change in a surrounding magnetic field during rotation. The change in the magnetic field is reflected in the distribution of the magnetic induction intensity of magnetic sensor 40 in the X-axis, Y-axis, and Z-axis directions. The X-axis direction is axial direction F of the rotating component, the magnetic induction intensity in the X-axis direction is Bx, the magnetic induction intensity in the Y-axis direction is B_{Y}, and the magnetic induction intensity in the Z-axis direction is B_{Z}. Periodical changes in the B_{X}, B_{Y}, and B_{Z} magnetic induction intensities when rotating component 20 rotates by one circle is shown in FIG. 7. By detecting the amplitude and phase of the magnetic induction intensity, a rotation angle of rotating component 20 can be calculated. Similarly, the key function of the crown is also realized by magnetic sensor 40 detecting the change in the surrounding magnetic field of magnetic component 30. When the key is pressed, that is, when rotating component 20 is displaced in axial direction F of the rotating component, the positions of magnetic component 30 and magnetic sensor 40 are changed relative to those when the key is not pressed, and this change is embodied by a change in the magnitude of the magnetic induction intensity sensed by magnetic sensor 40. By determining the change in the magnetic induction intensity, the detection on whether the key is pressed can be realized.

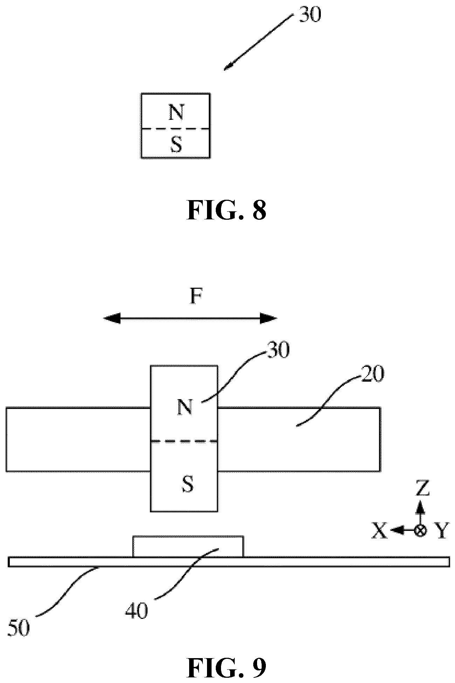

In another implementation, as shown in FIG. 8, magnetic component 30 may be strip-shaped. Strip-shaped magnetic component 30 is embedded on rotating component 20. As shown in FIG. 9, the N pole of magnetic component 30 is arranged at one end of magnetic component 30 away from magnetic sensor 40, and the S pole of magnetic component 30 is arranged at one end of magnetic component 30 close to magnetic sensor 40. The arrangement position of magnetic sensor 40 relative to magnetic component 30 may also be moved left and right.

In the present implementation, the rotation detection module further includes knob 90 fixedly connected to the end portion of rotating component 20 and arranged outside housing 10. knob 90 serves as an operating component for a user to rotate and/or press to drive the rotation of rotating component 20 and/or the displacement of rotating component 20 in axial direction F.

During use, the connector at one end of flexible circuit board 50 located outside housing 10 is connected to an electronic device. When knob 90 is rotated and/or pressed, it drives the rotation of rotating component 20 and/or the displacement of rotating component 20 in axial direction F, so that the magnetic field is changed. Magnetic sensor 40 acquires corresponding data and transmits the data to a mainboard of the electronic device. The mainboard controls other components of the electronic device according to the data to perform corresponding operations.

The rotation detection module further includes a damping component that cooperates with rotating component 20 to limit the rotation of rotating component 20. In this way, through the cooperation of the damping component and rotating component 20, a certain resistance will be generated when rotating component 20 is being rotated, and the rotation speed of rotating component 20 is thus slowed down, thereby providing the user a sense of damping and improving the comfort of user experience. In the present implementation, the damping component is arranged outside housing 10, and in other implementations, the damping component may also be arranged inside housing 10.

In the present implementation, the damping component and rotating component 20 are snap-fitted to limit the rotation of rotating component 20, but the present application is not limited to this. In other implementations, the damping component and rotating component 20 may also be realized by implementing the limited cooperation using other structures. For example, rotating component 20 is set as a rotating shaft with a rough peripheral surface, that is, the surface of the rotating shaft is provided with several protrusions in the circumferential direction, and the damping component forms a snap fit by being clamped between two adjacent protrusions on the surface of the rotating shaft. Alternatively, the surface of the rotating shaft is provided with several grooves in the circumferential direction, and the damping component forms a snap fit by being clamped in the groove on the surface of the rotating shaft.

In the present implementation, the other end portion of rotating component 20 is provided with gear 80, and the damping component is elastic structural body 70. Both gear 80 and elastic structural body 70 are located outside housing 10. One end of elastic structural body 70 is fixed to the outer surface of housing 10, and the other end is clamped in tooth space 81 of gear 80 for limiting the rotation of gear 80. The specific process of cooperation between elastic structural body 70 and gear 80 is as follows: when elastic structural body 70 is clamped into tooth space 81 of gear 80, the rotation of gear 80 will be limited; at the same time, elastic structural body 70 is elastic, and when a force for continuously rotating the rotating component 20 is greater than the maximum resistance bearable by elastic structural body 70, elastic structural body 70 will be bounced from tooth space 81 of gear 80, so that gear 80 and rotating component 20 will continue to rotate synchronously, and then elastic structural body 70 is reset under the action of its own elastic restoring force to enter the next tooth space 81 of gear 80, thereby repeating the above action, so that a continuous damping feeling is generated when rotating component 20 is being rotated. In the present implementation, elastic structural body 70 is arranged on the outer surface of housing 10 to cooperate with gear 80 arranged outside housing 10. In other implementations, elastic structural body 70 may also be arranged in housing 10 to cooperate with gear 80 arranged in housing 10.

In the present implementation, the end of elastic structural body 70 clamped in tooth space 81 of gear 80 is arc-shaped, which is more conducive to the repeated movement process of "bounce-reset" of elastic structural body 70.

In the rotation detection module of the above implementation, the overall structure is arranged to effectively reduce leakage of a magnetic field inside housing 10 and the impact of a magnetic field outside housing 10 to the rotation detection module, thereby improving the accuracy of detection. Moreover, the universal modular setting effectively reduces the production cost and has the beneficial effect of high versatility.

### Implementation 2

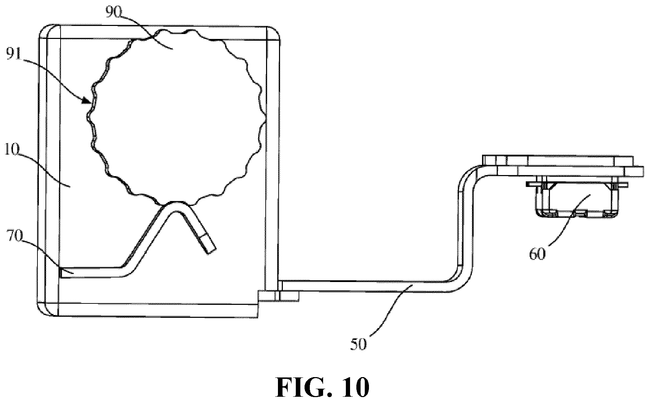

FIG. 10 is a three-dimensional structural view of a rotation detection module according to Implementation 2. The overall structure of the rotation detection module of the present implementation is basically the same as the structure in Implementation 1. A difference lies in that the damping component is arranged relative to knob 90, and the damping component cooperates with knob 90 to limit the rotation of rotating component 20. Specifically, the damping component is elastic structural body 70, and the rotation of rotating component 20 is limited by the cooperation of elastic structural body 70 and knob 90.

In the present implementation, knob 90 is cylindrical, and the surface is provided with grooves 91 in the circumferential direction. The arrangement of grooves 91 can meet the needs of rotation. Moreover, elastic structural body 70 may also be clamped in groove 91 on the surface of knob 90 to form a snap fit with knob 90, so that a damping feeling is generated when knob 90 is being rotated.

In other implementations, there may be two damping components, one of which forms a snap fit with knob 90, and the other may form a snap fit with the gear in Implementation 1. By arranging damping components at different positions at the same time, the damping feeling generated when rotating component 20 is being rotated is enhanced. However, the present application is not limited to this. The number of damping components may be more than two. The two or more damping components cooperate with different components fixedly connected to rotating component 20 and/or directly cooperate with rotating component 20, so that a continuous damping feeling is generated when rotating component 20 is being rotated.

In other implementations, a rebound mechanism may be arranged to achieve automatic reset of knob 90 after it is displaced in axial direction F of rotating component 20. That is, after knob 90 is pressed, knob 90 can be automatically reset by the rebound mechanism. Alternatively, a limit mechanism may also be arranged to limit the displacement of knob 90 in axial direction F of rotating component 20. That is, after knob 90 is pressed, knob 90 can remain in the pressed position, and then leave the pressed position under the action of an external force to return to an original position before being pressed. The structures of the rebound mechanism and the limit mechanism are based on the existing art, and will not be described in detail here.

In the rotation detection module of the above implementation, the overall structure is arranged to effectively reduce leakage of a magnetic field inside housing 10 and the impact of a magnetic field outside housing 10 to the rotation detection module, thereby improving the accuracy of detection. Moreover, the universal modular setting effectively reduces the production cost and has the beneficial effect of high versatility.

The above description is only preferred implementations of the present application and is not intended to limit the present application. Any modification, equivalent replacement, improvement, and the like made within the spirit and principle of the present application shall be included in the protection scope of the present application.

## Claims

1. A rotation detection module, comprising:
a housing, wherein the material of the housing is a magnetic shielding material;
a rotating component penetrating the housing;
a magnetic component located in the housing and rotating integrally with the rotating component; and
a magnetic sensor located in the housing and arranged relative to the magnetic component, wherein the magnetic sensor is configured to sense at least one of: a rotation angle of the magnetic component or displacement of the magnetic component in an axial direction of the rotating component.

2. The rotation detection module according to claim 1, wherein the rotation detection module further comprises a flexible circuit board inserted into the housing, and the magnetic sensor is arranged at one end of the flexible circuit board located in the housing.

3. The rotation detection module according to claim 2, wherein the end of the flexible circuit board located in the housing is fixed to an inner surface of the housing.

4. The rotation detection module according to claim 3, wherein an adhesive layer is arranged between the end of the flexible circuit board located in the housing and the inner surface of the housing, and the flexible circuit board is fixed to the inner surface of the housing through the adhesive layer.

5. The rotation detection module according to any one of claims 1-4, further comprising a damping component cooperating with the rotating component to limit the rotation of the rotating component.

6. The rotation detection module according to claim 5, wherein the damping component and the rotating component are snap-fitted to limit the rotation of the rotating component.

7. The rotation detection module according to claim 6, wherein an end portion of the rotating component is provided with a gear, and the damping component and the gear are snap-fitted to limit the rotation of the gear.

8. The rotation detection module according to claim 7, wherein the damping component is an elastic structural body, and an end portion of the elastic structural body is clamped in a tooth space of the gear to limit the rotation of the gear.

9. The rotation detection module according to any one of claims 1-8, further comprising a knob fixedly connected to an end portion of the rotating component and arranged outside the housing.

10. The rotation detection module according to claim 9, further comprising a damping component arranged relative to the knob, wherein the damping component cooperates with the knob to limit the rotation of the rotating component.

11. An electronic device, comprising the rotation detection module according to any one of claims 1-10.
